**Europäisches Patentamt**

**European Patent Office**

**Office européen des brevets**

(11) Numéro de publication : **0 301 635 B1**

(12) **FASCICULE DE BREVET EUROPEEN**

(45) Date de publication du fascicule du brevet :
**31.08.94 Bulletin 94/35**

(51) Int. Cl.$^5$ : **H03K 17/04**

(21) Numéro de dépôt : **88201508.4**

(22) Date de dépôt : **14.07.88**

(54) **Dispositif interrupteur pour signaux à haute fréquence.**

(30) Priorité : **24.07.87 FR 8710581**

(43) Date de publication de la demande :
**01.02.89 Bulletin 89/05**

(45) Mention de la délivrance du brevet :
**31.08.94 Bulletin 94/35**

(84) Etats contractants désignés :
**DE FR GB IT SE**

(56) Documents cités :
**FR-A- 1 320 327**
**US-A- 3 912 949**
**US-A- 3 959 750**

(73) Titulaire : **THOMSON-TRT DEFENSE**
**Rue Guynemer**
**F-78280 Guyancourt (FR)**
(84) **DE FR GB IT SE**

(72) Inventeur : **Petitjean, Gilbert Société Civile**
**S.P.I.D.**
**209, rue de l'Université**
**F-75007 Paris (FR)**
Inventeur : **Lebourg, Michel Société Civile**
**S.P.I.D.**
**209, rue de l'Université**
**F-75007 Paris (FR)**

(74) Mandataire : **Courtellemont, Alain et al**
**THOMSON-CSF,**
**SCPI,**
**B.P. 329,**
**50, rue Jean-Pierre Timbaud**
**F-92402 Courbevoie Cédex (FR)**

## Description

La présente invention concerne un dispositif interrupteur pour signaux à haute fréquence, dispositif comportant d'une part un circuit d'interruption formé d'un trajet de signaux à haute fréquence, dans lequel est inséré en série un moyen semi-conducteur (notamment diodes PIN) recevant, d'une borne de commande du circuit d'interruption des signaux de commande pour le mettre à l'état passant ou non passant, et d'un circuit de polarisation pour assurer un découplage entre les signaux à haute fréquence et des signaux de commande et d'autre part, un circuit de commande pour fournir, en fonction d'une information de commande, les signaux de commande à partir de soit une première source de tension pour rendre passant ledit trajet, soit une deuxième source de tension pour le rendre non passant, le circuit de commande comportant un premier et un deuxième transistor final et un circuit de surintensité, déclenché lors du passage de la première source à la deuxième pour fournir une impulsion de courant afin de charger rapidement un condensateur de découplage dont l'armature interne est reliée à ladite borne de commande et dont l'armature externe est reliée à la masse.

Un tel dispositif trouve d'importantes applications. Par exemple, plusieurs dispositifs peuvent être combinés pour commuter un émetteur de signaux haute fréquence sur différents circuits de charge.

Un dispositif de ce genre est décrit dans le brevet des Etats-Unis d'Amérique n° 3 912 949. Dans ce brevet, on préconise, pour accélérer le changement d'états (passant, non-passant et non-passant, passant) de produire des pointes de courant pour évacuer les charges emmagasinées dans les diodes PIN. Si cette mesure indiquée dans le brevet est efficace pour des signaux à haute fréquence de faible puissance, elle n'est pas applicable pour des signaux à forte puissance (de l'ordre de 100 watts). En effet à cette puissance, pour que les diodes PIN ne rentrent pas en conduction sur des crêtes de tension haute fréquence, alors qu'elles doivent être bloquées, on est contraint d'avoir une deuxième source de tension de valeur élevée, supérieure à la valeur crête des tensions à haute fréquence. On ne peut plus alors créer, sans précautions, des pointes de courant génératrices de surtensions qui, additionnées à la valeur élevée de la deuxième source de tension, et du fait que ces surtensions sont appliquées sur les diodes PIN, amènent un risque important de provoquer le claquage des diodes PIN.

De plus, il importe d'avoir un bon découplage entre les signaux à haute fréquence et les signaux de commande, ce qui implique en pratique d'avoir une capacité au niveau de la borne de commande afin de shunter les signaux à haute fréquence. La demanderesse s'est aperçue que cette capacité était surtout responsable du ralentissement de l'application des signaux de commande aux électrodes de la (des) diode (s) PIN.

La présente invention propose donc un dispositif du genre cité dans le préambule particulièrement adapté aux signaux à haute fréquence (100 à 400 MHz) et de forte puissance (100 W crête), utilisant une deuxième source de blocage de valeur élevée tout en présentant une bonne rapidité de changements d'états.

Pour cela, un dispositif du genre mentionné dans le préambule est remarquable en ce que le collecteur du premier transistor final est relié directement à la première source de tension, en ce que le collecteur du deuxième transistor final est relié directement à la deuxième source de tension, en ce que la sortie du circuit de surintensité est reliée à la base du deuxième transistor final tandis que son entrée comporte un réseau différentiateur pour détecter le passage de la première source à la deuxième en différentiant l'information de commande et en ce que la constante de temps du réseau différentiateur est choisie pour déclencher le circuit de surintensité en phase avec la charge du condensateur de découplage.

La description suivante en regard du dessin annexé, le tout donné à titre d'exemple non limitatif, fera bien comprendre comment l'invention peut être réalisée.

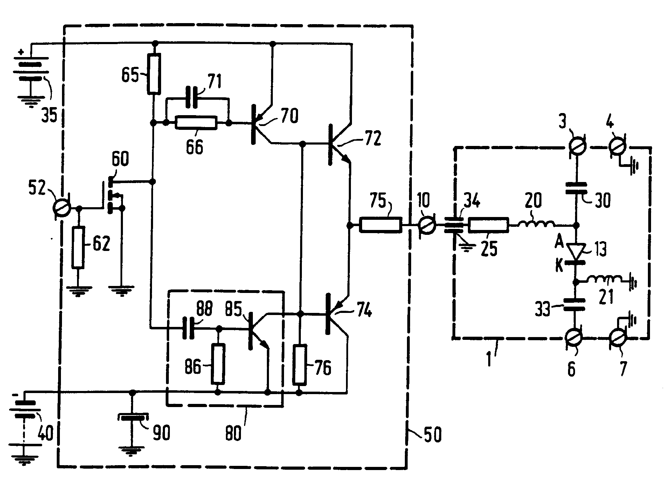

La figure 1, unique, représente le dispositif de l'invention.

A la figure 1, la référence 1 indique un circuit d'interruption muni de bornes d'entrée 3 et 4 pour être connectées à un générateur de signaux haute fréquence, de bornes de sortie 6 et 7 pour être connectées à un circuit de charge et d'une borne de commande 10 pour recevoir un signal de commande. Ce signal a pour but de rendre passant ou non-passant le trajet de signaux à haute fréquence compris entre les bornes d'entrée 3 et 4 et les bornes de sortie 6 et 7. En d'autres termes, ce trajet est dit passant lorsque la puissance fournie aux bornes 3 et 4 se trouve aux bornes 6 et 7 et non-passant lorsqu'on ne retrouve aucune puissance aux bornes 6 et 7, alors que de la puissance est appliquée aux 3 et 4. Pour rendre passant ou non-passant ce trajet, on utilise une diode PIN 13 aux extrémités A et K de laquelle on applique une tension de polarisation qui la rend soit passante, soit non-passante. Un circuit de polarisation permet d'appliquer cette tension ; il est formé des self-inductances 20 et 21. La self 21 connecte, au point de vue courant continu, l'extrémité K de la diode 13 à la masse à laquelle sont déjà reliées les bornes 4 et 7. La self 20 interconnecte l'extrémité A à la borne 10 par l'intermédiaire d'une résistance 25. Le circuit de polarisation comporte encore deux condensateurs d'isolement 30 et 33, pour isoler vis à vis du signal de commande l'extrémité A de la borne 3 d'une part, et l'extrémité K de la borne 6 d'autre part. On notera aussi la présence d'un condensateur de découplage (by-pass capacitor dans la littérature anglo-saxonne) 34 qui court-circuite les signaux à haute fréquence résiduels ;

ce condensateur 34 a une armature intérieure cylindrique, reliée au conducteur qui va de la borne 10 à la résistance 25 et une armature extérieure cylindrique qui est à la masse ou, plus précisément, en contact avec le boîtier qui entoure le circuit d'interruption 1, ce boîtier étant lui-même relié à la masse. La valeur de ce condensateur est de l'ordre de 2 000 pF et c'est elle qui ralentit la montée et la descente des signaux de commande. Pour rendre passante la diode 13, on doit appliquer une tension provenant d'une première source de tension 35 positive par rapport à la masse et dont la force électromotrice est de 5 Volts. Pour bloquer la diode 13 on doit appliquer une autre tension provenant d'une deuxième source de tension 40 négative par rapport à la masse et dont la force électromotrice est de 100 volts. Pour appliquer ces tensions à la borne 10, on utilise le circuit de commande 50 qui, en fornction d'une information de commande appliquée à la borne 52, fournit une des deux tensions des sources 35 et 40. Cette information est constituée par des niveaux logiques ; ainsi, une tension proche de 0 Volt provoque l'application à la borne 10 de la tension de la source 40 et une tension proche de 5 Volts l'application de la tension de la source 35. Ce circuit de commande 50 est tout d'abord constitué par un transistor à effet de champ 60 à canal N formant ainsi un préamplificateur présentant une forte impédance à la borne 52 ; sa grille est connectée d'une part à cette borne 52 et d'autre part à la masse via une résistance 62 de forte valeur (env. 100 kohms) ; la source est reliée à la masse et son drain au point commun à deux résistances 65 et 66 ; les points opposés de ces deux résistances 65 et 66 sont reliés respectivement au pôle positif de la source 35 et à la base d'un transistor PNP 70. Un condensateur 71 shunte la résistance 66 pour améliorer la rapidité de la réponse du transistor 70. L'émetteur de ce transistor 70 est relié au pôle "+" de la source 35 et le collecteur aux bases d'un premier transistor final 72 de type NPN et d'un deuxième transistor final 74 de type PNP. Ces transistors finaux sont montés en opposition (paire complémentaire), c'est-à-dire que leurs émetteurs, connectés ensemble, sont reliés à la borne 10 par l'intermédiaire d'une résistance 75, leurs bases connectées aussi ensemble sont reliées au collecteur du transistor 70 et au pôle "-" de la source 40 par l'intermédiaire d'une résistance 76. Le collecteur du transistor 72 est relié au pôle "+" de la source 35 et le collecteur du transistor 74 au pôle "-" de la source 40.

Il est facile de comprendre le fonctionnement du montage qui vient d'être décrit.

Lorsque l'information à la borne 52 est un "1" logique, c'est-à-dire que l'on a une tension de 5 Volts à cette borne, le transistor 60 est saturé ; il en découle que le transistor 70 le devient aussi, de sorte que le transistor 72 est conducteur et le transistor PNP 74 est bloqué puisque le potentiel de sa base est supérieur à celui de son émetteur. Le condensateur 34 se charge vite du fait que le transistor 72 est conducteur.

Lorsque l'information à la borne 52 est un "0" le potentiel au drain du transistor 60 s'élève, bloquant le transistor 70, ce qui entraîne le blocage du transistor 72 ; le transistor 74 devient conducteur, son courant d'émetteur étant fixé par la valeur de la résistance 76 ainsi que par les résistances de fuite des transistors 70 et 72. Etant donnée la valeur élevée (- 100 Volt) de la force électromotrice de la source 40, il y a lieu de prendre des mesures pour éviter que le transistor n'ait à dissiper une puissance trop importante ; c'est pour cela que la résistance de polarisation 76 a une valeur élevée. Ainsi, bien que la diode 13 soit à l'état bloqué, on se garantit contre toute impédance offrant des passages pour des courants de fuite intempestifs. Cependant, le courant d'émetteur du transistor 74 ainsi polarisé est trop faible pour assurer une charge rapide du condensateur 34. C'est pour cela que l'invention préconise un circuit de surintensité 80 déclenché lors du passage de la première source 35 à la seconde source 40 pour fournir une impulsion de courant de charge de la capacité présente à la borne 10, via le transistor 74.

Comme l'impulsion a une durée brève le transistor 74 n'est soumis à une forte puissance à dissiper que pendant peu de temps, ce qui ne met pas sa vie en danger.

Le circuit de surintensité 80 est formé par un transistor 85 dont le collecteur est relié à la base du transistor 74. L'émetteur du transistor 85 est relié au pôle "-" de la source 40 tandis que la base est d'une part connectée au pôle "-" de la source 40 par l'intermédiaire d'une résistance 86 et d'autre part au drain du transistor 60 par l'intermédiaire d'un condensateur 88 qui constitue ainsi avec la résistance 86 et la résistance d'entrée du transistor 85 un réseau différentiateur. Ainsi monté, le transistor 85 fournit des impulsions de courant à la base du transistor 74, à chaque front montant de la tension présente au drain du transistor 60, ce qui survient lors du passage de la première source vers la deuxième. La durée de l'impulsion fournie par le circuit 80 dépend notamment de la valeur de la capacité du condensateur 88. On a donc choisi une valeur de la capacité qui assure une charge exponentielle du condensateur 34, ceci pour éviter toute surtension à ses bornes.

Lorsque le circuit de surintensité est déclenché, la source de tension 40 doit fournir un courant relativement important et la tension à ses bornes peut faiblir ; c'est pour cela qu'on a prévu un condensateur 90 de forte valeur (condensateur réservoir) qui renforce l'efficacité de la source 40.

Le tableau suivant donne les valeurs des différents éléments du dispositif .

3

## TABLEAU

| Résistances | Valeurs |
|---|---|
| 25 | 27 ohms |
| 62 | 150 kohms |
| 65 | 2,2 kohms |
| 66 | 100 kohms |
| 75 | 10 ohms |
| 76 | 330 kohms |
| 86 | 150 kohms |
| **Condensateur** | |
| 30 | 470 pF |
| 33 | 470 pF |
| 35 | 1-2 nF |
| 71 | 1 nF |
| 88 | 1 nF |
| 90 | 3,9 µF |
| **Selfs** | |
| 20 | 1 µH |
| 21 | 1 µH |
| **Semiconducteurs** | |
| 13 | DH 804-01 |
| 60 | 2N6660 |
| 70 | 2N3634 |
| 72 | 2N720A |
| 74 | 2N3634 |
| 85 | 2N720A |

Avec un tel montage, on obtient un temps de commutation inférieur à 5 µs par état passant état non-passant et réciproquement.

Ce temps de commutation est conservé pour une fréquence de répétition du signal de commande inférieure ou égale à 500 Hz.

**Revendications**

1. Dispositif interrupteur pour signaux à haute fréquence, dispositif comportant d'une part un circuit d'interruption (1) formé d'un trajet de signaux à haute fréquence dans lequel est inséré en série un moyen semi-conducteur (13) unidirectionel à deux électrodes (notamment diodes PIN) recevant d'une borne de commande (10) du circuit d'interruption des signaux de commande pour le mettre à l'état passant ou non passant, et d'un circuit de polarisation (20, 21) pour assurer un découplage entre les signaux à haute fréquence et des signaux de commande et d'autre part, un circuit de commande (50) pour fournir, en fonction d'une information de commande, les signaux de commande à partir de soit une première source de tension (35) pour rendre passant ledit trajet, soit une deuxième source de tension (40) pour le rendre non passant, le circuit de commande comportant un premier (72) et un deuxième (74) transistor final et un circuit de surintensité (80), déclenché lors du passage de la première source à la deuxième pour fournir une impulsion de courant afin de charger rapidement un condensateur de découplage (34) dont l'armature interne est reliée à ladite borne de commande et dont l'armature externe est reliée à la masse caractérisé en ce que le collecteur du premier transistor final (72) est relié directement à la première source de tension (35), en ce que le collecteur du deuxième transistor final (74) est relié directement à la deuxième source de tension (40), en ce que la sortie du circuit de surintensité est reliée à la base du deuxième transistor final tandis que son entrée comporte un réseau différentiateur pour détecter le passage de la première source à la deuxième en différentiant l'information de commande et en ce que la constante de temps du réseau différentiateur est choisie pour déclencher le circuit de surintensité en phase avec la charge du condensateur de découplage (34).

2. Dispositif interrupteur selon la revendication 1, caractérisé en ce que le moyen semi-conducteur est constitué par une diode unique (13).

## Patentansprüche

1. Unterbrechervorrichtung für Hochfrequenzsignale, die einerseits eine Unterbrecherschaltung (1) bestehend aus einer Hochfrequenzsignalstrecke, in die in Reihe ein in einer Richtung leitender und zwei Elektroden besitzender Halbleiter (13), (insbesondere eine PIN-Diode) eingefügt ist, der von einer Steuerklemme (10) der Unterbrecherschaltung Steuersignale zu deren Umschaltung vom leitenden in den nichtleitenden Zustand empfängt, und aus einem Vorspannungskreis (20, 21), um eine Entkopplung zwischen den Hochfrequenzsignalen und den Steuersignalen zu gewährleisten, und die andererseits eine Steuerschaltung (50) enthält, um abhängig von einer Steuerinformation die Steuersignale entweder von einer ersten Spannungsquelle (35) zu liefern, um die Strecke leitend zu machen, oder von einer zweiten Spannungsquelle (40), um die Strecke nichtleitend zu machen, wobei die Steuerschaltung einen ersten (72) und einen zweiten Endstufentransistor (74) sowie einen Überspannungskreis (80) enthält, der beim Übergang von der ersten Quelle zur zweiten Quelle ausgelöst wird, um einen Stromimpuls liefern, mit dem schnell ein Entkopplungskondensator (34) geladen wird, dessen innere Elektrode mit der Steuerklemme und dessen äußere Elektrode mit Masse verbunden ist, dadurch gekennzeichnet, daß der Kollektor des ersten Endstufentransistors (72) unmittelbar mit der ersten Spannungsquelle (35) verbunden ist, daß der Kollektor des zweiten Endstufentransistors (74) unmittelbar mit der zweiten Spannungsquelle (40) verbunden ist, daß der Ausgang des Überspannungskreises mit der Basis des zweiten Endstufentransistors verbunden ist, während sein Eingang ein Differenziernetz enthält, um den Übergang von der ersten Quelle zur zweiten zu erfassen, indem die Steuerinformation differenziert wird, und daß die Zeitkonstante des Differenziernetzes so gewählt wird, daß der Überspannungskreis in Phase mit dem Laden des Entkopplungskondensators (34) ausgelöst wird.

2. Unterbrechervorrichtung nach Anspruch 1, dadurch gekennzeichnet, daß das Halbleitermittel aus einer einzigen Diode (13) besteht.

## Claims

1. Switching device for high-frequency signals, the device including, on the one hand, a switching circuit (1) formed by a high-frequency signal path in which a unidirectional, two-electrode semiconducting means (13) (especially PIN diodes) is inserted in series, receiving control signals, from a control terminal (10) of the switching circuit, in order to put it in the conducting or non-conducting state, and by a bias circuit (20, 21) for providing decoupling between the high-frequency signals and control signals, and, on the other hand, a control circuit (50) for supplying the control signals, depending on control information, from either a first voltage source (35) for making the said path conducting, or a second voltage source (40) for making it non-conducting, the control circuit including a first (72) and a second (74) final transistor and an overcurrent circuit (80), triggered upon passing from the first source to the second in order to supply a current pulse so as rapidly to charge a decoupling capacitor (34) the inner plate of which is linked to the said control terminal and the outer plate of which is linked to earth, characterized in that the collector of the first final transistor (72) is linked directly to the first voltage source (35), in that the collector of the second final transistor (74) is linked directly to the second voltage source (40), in that the output of the overcurrent circuit is linked to the base of the second final transistor while its input includes a differentiating network for detecting the passing from the first source to the second by differentiating the control information, and in that the time constant of the differentiating network is chosen to trigger the overcurrent circuit in phase with the charging of the decoupling capacitor (34).

2. Switching device according to Claim 1, characterized in that the semiconductor means consists of a single diode (13).